# DEMANDE DE BREVET EUROPEEN

(11) **EP 3 290 778 A1**
(43) Date de publication de la demande: **07.03.2018**
(21) Numéro de dépôt: 17184555.5
(22) Date de dépôt: 02.08.2017
(51) Int. Cl.: F21S 41/19, F21K 9/20, B60Q 1/00, B60Q 1/26, F21V 19/00, F21Y 115/10, F21S 41/147, F21S 41/39

(54) **MODULE LUMINEUX COMPRENANT AU MOINS UNE SOURCE LUMINEUSE AMOVIBLE**

(30) Priorité: 30.08.2016 FR 1658031
(71) Demandeur: Valeo Vision, 93012 Bobigny Cedex (FR)
(72) Inventeur: BLUSSEAU, Eric, 93012 BOBIGNY Cedex (FR)

(57) **Abrégé**

Module lumineux (10) pour véhicule automobile, ledit module lumineux (10) comprenant :
- un moyen optique (3) monté fixe dans le module lumineux (10), ledit moyen optique (3) comprenant une base (30) avec un premier logement (12A) ;
- un support (5) du moyen optique (3) mobile par rapport au moyen optique (3) autour d'un axe de rotation (6), ledit support (5) du moyen optique (3) comprenant une base (50) avec un deuxième logement (12B), ledit support (5) du moyen optique (3) étant adapté pour prendre :
- une position de fermeture pour maintenir au moins une source lumineuse (7) en partie dans ledit premier logement (12A) et en partie dans ledit deuxième logement (12B) ; et
- une position d'ouverture pour retirer ladite au moins une source lumineuse (7) du module lumineux (10) ;

- ladite au moins une source lumineuse (7) étant amovible et comprenant :
- des moyens d'émission de lumière (11) ;
- un support mécanique (13) des moyens d'émission de lumière (11).

## Description

### DOMAINE TECHNIQUE DE L'INVENTION

La présente invention concerne un module lumineux pour véhicule automobile.
Elle trouve une application particulière mais non limitative dans les dispositifs d'éclairage, tels que des projecteurs de véhicule automobile.

### ARRIÈRE-PLAN TECHNOLOGIQUE DE L'INVENTION

Un module lumineux pour véhicule automobile comprend de manière connue de l'homme du métier :
- un moyen optique;
- un support du moyen optique;
- au moins une source lumineuse logée dans le module lumineux.
La source lumineuse comprend :
- des moyens d'émission de lumière;
- un support mécanique des moyens d'émission de lumière.
La durée de vie d'une source lumineuse, telle qu'une puce émettrice semi-conductrice est globalement supérieure à 3 000 heures de fonctionnement. En cas de panne, la question du remplacement de cette source lumineuse se pose. Afin de remplacer une source lumineuse défectueuse, il est connu de retirer l'ensemble du module lumineux, c'est-à-dire le moyen optique et la source lumineuse défectueuse.
Un inconvénient de cet état de la technique, est que le remplacement de l'ensemble du module lumineux entraîne la mise au rebut d'éléments, tel que le moyen optique, éléments qui ne sont pas nécessairement défectueux. Il est ainsi nécessaire pour l'opérateur d'acheter un nouveau module lumineux complet à chaque fois qu'une source lumineuse est défectueuse, ce qui rend plus coûteuse l'opération de remplacement du module lumineux.

Dans ce contexte, la présente invention vise à résoudre l'inconvénient précédemment mentionné.

### DESCRIPTION GENERALE DE L'INVENTION

A cette fin l'invention propose un module lumineux pour véhicule automobile, ledit module lumineux comprenant :
- un moyen optique monté fixe dans le module lumineux, ledit moyen optique comprenant une base avec un premier logement;
- un support du moyen optique mobile par rapport au moyen optique autour d'un axe de rotation, ledit support du moyen optique comprenant une base avec un deuxième logement, ledit support du moyen optique étant adapté pour prendre :
   - une position de fermeture pour maintenir au moins une source lumineuse en partie dans ledit premier logement et en partie dans ledit deuxième logement; et
   - une position d'ouverture pour retirer ladite au moins une source lumineuse du module lumineux ;
- ladite au moins une source lumineuse étant amovible et comprenant :
   - des moyens d'émission de lumière ;
   - un support mécanique des moyens d'émission de lumière.

Ainsi, comme on va le voir en détail ci-après, la source lumineuse amovible est placée dans un logement formé en partie d'un premier logement appartenant au moyen optique et en partie d'un deuxième logement appartenant au support du moyen optique. Le support du moyen optique est mobile par rapport au moyen optique entre une position de fermeture et une position d'ouverture. En position d'ouverture, la source lumineuse est accessible par un opérateur et il est alors possible de retirer la source lumineuse défectueuse hors du module lumineux. Seule la source lumineuse est alors remplacée, ce qui diminue le coût global de cette opération de maintenance.

Selon des modes de réalisation non limitatifs, le module lumineux peut comporter en outre une ou plusieurs caractéristiques supplémentaires parmi les suivantes :
Selon un mode de réalisation non limitatif, la source lumineuse est bloquée dans le premier logement ou dans le deuxième logement :
   - selon une direction longitudinale en deux points de référence primaires via deux moyens de blocage primaires de la base du moyen optique ou de la base du support du moyen optique;
   - selon une direction transversale, perpendiculaire à la direction longitudinale, en au moins un point de référence secondaire via un moyen de blocage secondaire.
En particulier, la source lumineuse est bloquée dans le premier logement ou dans le deuxième logement lorsque le support du moyen optique est en position de fermeture.

Selon un mode de réalisation non limitatif, un moyen de blocage primaire est une lame ressort.

Selon un mode de réalisation non limitatif, un moyen de blocage primaire est un chanfrein.

Selon un mode de réalisation non limitatif, un moyen de blocage secondaire est une lame ressort de la base du moyen optique.

Selon un mode de réalisation non limitatif, un deuxième moyen de blocage secondaire est utilisé pour bloquer la source lumineuse selon la direction transversale, ledit deuxième moyen de blocage secondaire étant un chanfrein de la base du moyen optique en regard de ladite lame ressort, le chanfrein et la lame ressort étant disposés de part et d'autre de la source lumineuse.

Selon un mode de réalisation non limitatif, le moyen optique et le support du moyen optique sont reliés mécaniquement entre eux pour assurer un guidage en rotation du support du moyen optique par rapport au moyen optique.

Selon un mode de réalisation non limitatif, le module lumineux comporte en outre des moyens de déplacement du support du moyen optique par rapport au moyen optique adaptés pour permettre un déplacement en rotation du support du moyen optique entre ladite position de fermeture et ladite position d'ouverture.

Selon un mode de réalisation non limitatif, les moyens de déplacement sont un ressort de rappel.

Selon un mode de réalisation non limitatif, la source lumineuse est adaptée pour être positionnée dans ledit premier logement du moyen optique lorsque le support du moyen optique est en position d'ouverture.

Selon un mode de réalisation non limitatif, le moyen optique comprend :
- au moins deux moyens de blocage primaires pour le blocage de la source lumineuse dans le premier logement selon la direction longitudinale;
- au moins un moyen de blocage secondaire pour le blocage de la source lumineuse dans le premier logement selon la direction transversale.

Selon un mode de réalisation non limitatif, la source lumineuse est adaptée pour être positionnée dans ledit deuxième logement du support du moyen optique lorsque ledit support est en position d'ouverture.

Selon un mode de réalisation non limitatif, le moyen optique comprend :
- au moins deux moyens de blocage primaires pour le blocage de la source lumineuse dans le premier logement selon la direction longitudinale;
- au moins un moyen de blocage secondaire pour le blocage de la source lumineuse dans le premier logement selon la direction transversale.

Selon un mode de réalisation non limitatif, le support du moyen optique comprend deux moyens de blocage primaires pour le blocage de la source lumineuse dans le deuxième logement selon la direction longitudinale.

Selon un mode de réalisation non limitatif, la source lumineuse est bloquée dans le premier logement selon une direction normale en au moins trois points de référence tertiaire.

Selon un mode de réalisation non limitatif, les trois points de référence tertiaire sont trois ergots appartenant à un capot de protection de la source lumineuse, lesdits ergots étant adaptés pour coopérer avec une contre-forme appartenant à la base du moyen optique.

Selon un mode de réalisation non limitatif, le module lumineux comprend en outre des moyens de verrouillage pour le verrouillage du moyen optique avec le support du moyen optique.

Selon un mode de réalisation non limitatif, le module lumineux comprend en outre des moyens de calage pour le maintien d'un connecteur électrique externe de la source lumineuse sur ledit module lumineux.

Selon un mode de réalisation non limitatif, le support du moyen optique est un radiateur.

Selon un mode de réalisation non limitatif, lequel les moyens d'émission de lumière comportent une puce émettrice semi-conductrice.

### BREVE DESCRIPTION DES FIGURES

L'invention et ses différentes applications seront mieux comprises à la lecture de la description qui suit et à l'examen des figures qui l'accompagnent.
- la figure 1 représente schématiquement une vue de côté d'un module lumineux pour véhicule automobile selon un mode de réalisation non limitatif de l'invention, ledit module lumineux comprenant un moyen optique et un support du moyen optique dans une position de fermeture dans laquelle une source lumineuse est maintenue dans ledit module lumineux ;
- la figure 2 représente schématiquement une vue de côté du module lumineux de la figure 1 selon un mode de réalisation non limitatif, ledit support du moyen optique étant dans une position d'ouverture dans laquelle la source lumineuse est accessible;
- les figures 3 et 4 représentent une vue de dessus de la source lumineuse lorsqu'elle est maintenue en partie dans un premier logement du moyen optique et en partie dans un deuxième logement du support du moyen optique du module lumineux de la figure 1 selon une direction longitudinale X et selon une direction transversale Y, selon un premier mode de réalisation non limitatif ;
- les figures 5 et 6 représentent une vue de dessus de la source lumineuse lorsqu'elle est maintenue en partie dans un premier logement du moyen optique et en partie dans un deuxième logement du support du moyen optique du module lumineux de la figure 1, selon la direction longitudinale X et selon la direction transversale Y, selon un second mode de réalisation non limitatif;
- la figure 7 représente une vue de dessus de la source lumineuse lorsqu'elle est maintenue en partie dans un premier logement du moyen optique et en partie dans un deuxième logement du support du moyen optique du module lumineux de la figure 1, selon la direction longitudinale X et selon la direction transversale Y, selon un troisième mode de réalisation non limitatif;
- La figure 8 est une vue en coupe selon un axe A-A' de la figure 3 au niveau d'un moyen de blocage de la source lumineuse dans le premier logement du moyen optique;
- Les figures 9 et 10 représentent selon un mode de réalisation non limitatif une vue de dessus de la source lumineuse lorsqu'elle est maintenue dans le module lumineux de la figure 1 selon une direction normale Z ;
- La figure 11 représente selon un mode de réalisation non limitatif une vue en coupe du module lumineux de la figure 1, ledit module lumineux comprenant des moyens de verrouillage;
- La figure 12 représente selon un mode de réalisation non limitatif une vue en coupe du module lumineux de la figure 1, ledit module lumineux comprenant des moyens de calage pour le maintien d'un connecteur d'alimentation de la source lumineuse sur ledit module lumineux.

### DESCRIPTION DE MODES DE REALISATION DE L'INVENTION

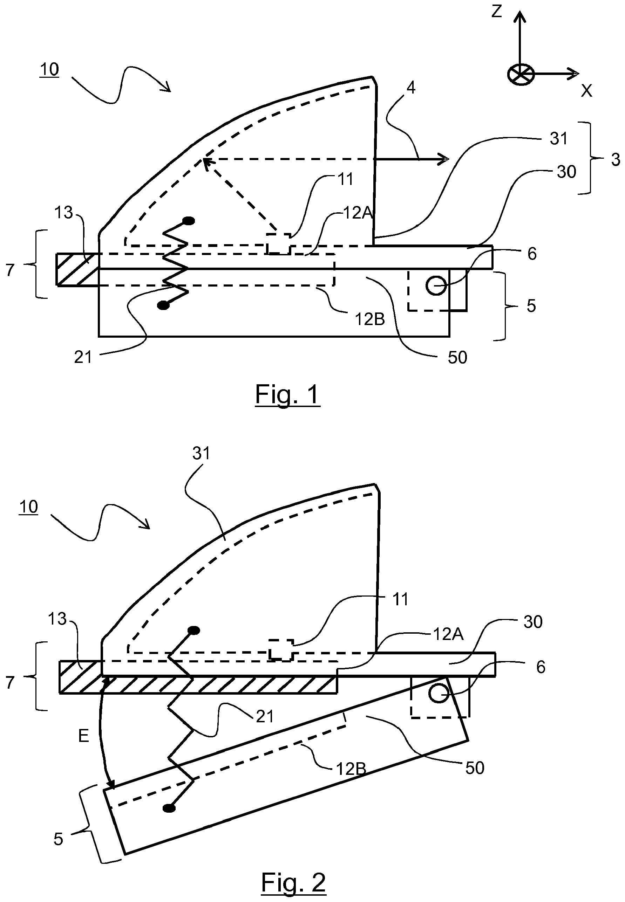

Les éléments identiques, par structure ou par fonction, apparaissant sur différentes figures conservent, sauf précision contraire, les mêmes références.
Le module lumineux 10 pour véhicule automobile selon l'invention est décrit en référence aux figures 1 à 11.
Par véhicule automobile, on entend tout type de véhicule motorisé.

Dans un mode de réalisation non limitatif pris dans la suite de la description, le module lumineux 10 appartient à un dispositif d'éclairage et/ou de signalisation. Dans une variante de réalisation non limitative, le dispositif d'éclairage et/ou de signalisation est un projecteur de véhicule automobile.

Comme illustré sur les figures 1 à 2, le module lumineux 10 comprend :
- un moyen optique 3 monté fixe dans le module lumineux 10. Ce moyen optique comprend une base 30 délimitant un premier logement 12A ;
- un support 5 du moyen optique 3 mobile par rapport au moyen optique 3 autour d'un axe de rotation 6. Ce support 5 du moyen optique 3 comprend une base 50 délimitant un deuxième logement 12B. Le support 5 du moyen optique 3 est adapté pour prendre :
   - une position de fermeture pour maintenir au moins une source lumineuse 7 en partie dans le premier logement 12A et en partie dans le deuxième logement 12B ; et
   - une position d'ouverture pour retirer la source lumineuse 7 du module lumineux 10.
- la source lumineuse 7 est amovible et comprend :
   - des moyens d'émission de lumière 11 ;
   - un support mécanique 13 des moyens d'émission de lumière 11.

Le module lumineux 10 est adapté pour émettre des rayons lumineux 4 formant un faisceau lumineux. Dans un exemple non limitatif, le module lumineux 10 est adapté pour assurer une fonction photométrique dite « high beam » pour réaliser un feu de route. Dans un autre exemple non limitatif, le module lumineux 10 est adapté pour assurer une fonction photométrique dite « low beam » pour réaliser, par exemple, un feu de croisement.

Les différents éléments du module lumineux 10 sont décrits en détail ci-après.

### • Moyen optique

Dans un mode de réalisation non limitatif, le moyen optique 3 est :
- un réflecteur ;
- une lentille; ou
- un guide de lumière; ou
- un collimateur.

Le moyen optique 3 coopère avec la source lumineuse 7 décrite ci-après pour former les rayons lumineux 4.
Dans l'exemple non limitatif illustré sur les figures 1, 2, 9, 10 et 11, le moyen optique 3 est un réflecteur qui comprend un miroir 31 et une base 30.

### • Source lumineuse

Outre les moyens d'émission de lumière 11 et le support mécanique 13, la source lumineuse 7 comprend une interface de connexion électrique 16. L'interface de connexion électrique 16 est adaptée pour l'alimentation électrique et le pilotage des moyens d'émission de lumière 11.
L'interface de connexion électrique 16 est adaptée pour coopérer avec un connecteur électrique externe qui permet d'envoyer des commandes de pilotage à la source lumineuse 7 et de l'alimenter.
La source lumineuse 7 est adaptée pour coopérer avec le module optique 3.

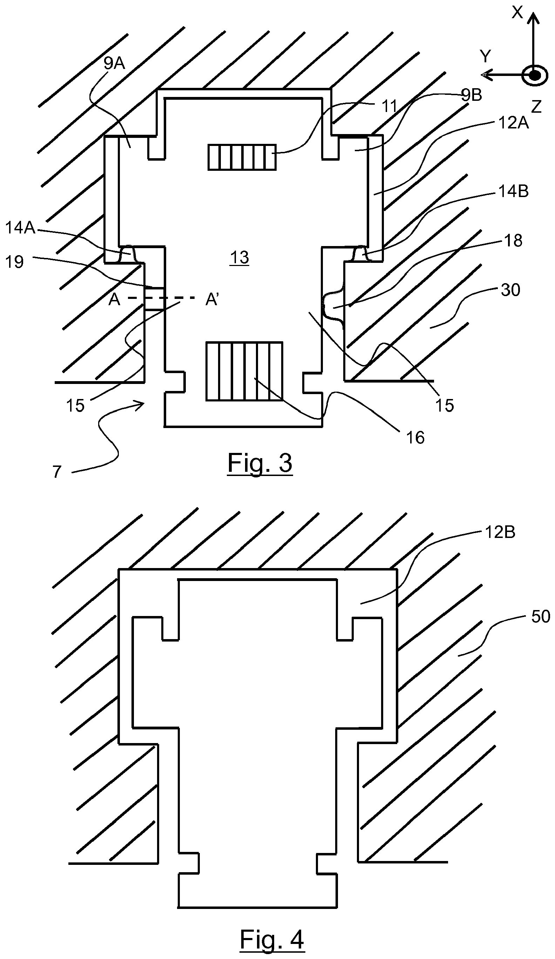

Dans un mode de réalisation non limitatif, la source lumineuse 7 comprend une pluralité de moyens d'émission de lumière 11. Dans l'exemple non limitatif illustré sur les figures 3, 5, 8, il y six moyens d'émission de lumière. Dans un mode de réalisation non limitatif, les moyens d'émission de lumière 11 comportent au moins une puce émettrice semi-conductrice.
Dans une variante de réalisation non limitative, une puce émettrice semi-conductrice fait partie d'une diode électroluminescente. Par diode électroluminescente, on entend tout type de diodes électroluminescentes, que ce soit dans des exemples non limitatifs des LED (« Light Emitting Diode »), une OLED (« Organic LED ») ou une AMOLED (« Active-Matrix-Organic LED »), ou encore une FOLED (« Flexible OLED »).
La source lumineuse 7 est amovible, à savoir elle peut être retirée du module lumineux 10 sans retirer le module optique 3 dudit module lumineux 10. La source lumineuse 7 est ainsi interchangeable.

### • Support du moyen optique

Dans un mode de réalisation non limitatif, le support 5 du moyen optique 3 est un radiateur qui permet d'évacuer la chaleur provenant de la source lumineuse 7 hors du module lumineux 10.
Le support 5 du moyen optique 3 est mobile par rapport au moyen optique 3 et c'est son déplacement entre la position de fermeture et la position d'ouverture qui va permettre le retrait de la source lumineuse 7 hors du module lumineux 10.

Dans un mode de réalisation non limitatif, le moyen optique 3 et le support 5 du moyen optique 3 sont reliés mécaniquement au niveau de l'axe de rotation 6 de sorte à assurer un guidage en rotation du support 5 du moyen optique 3 par rapport audit moyen optique 3.

Dans un mode de réalisation non limitatif, le module lumineux 10 comporte des moyens de déplacement 21 du support 5 du moyen optique 3 par rapport au moyen optique 3. Ces moyens de déplacement 21 sont adaptés pour permettre un déplacement en rotation du support 5 du moyen optique 3 entre sa position de fermeture et sa position d'ouverture.

Dans un mode de réalisation non limitatif tel qu'illustré sur la figure 1, les moyens de déplacement 21 sont un ressort de rappel.
Dans la position de fermeture du support 5 du moyen optique 3 illustrée à la figure 1, le ressort de rappel 21 est au repos.
Dans la position d'ouverture du support 5 du moyen optique 3 illustrée à la figure 2, le ressort de rappel 21 est en tension.
Dans l'exemple de réalisation de cette figure 2, le support 5 du moyen optique 3 est maintenu dans cette position d'ouverture par l'opérateur pour permettre le retrait de la source lumineuse 7 hors du module lumineux 10. Une fois la source lumineuse 7 retirée, l'opérateur relâche le support 5 du moyen optique 3. Celui-ci est alors ramené contre le moyen optique 3 par l'action du ressort de rappel 21. Le ressort de rappel 21 permet ainsi de ramener rapidement et automatiquement le support 5 du moyen optique 3 dans sa position de fermeture. En outre, le ressort de rappel 21 permet de compenser un jeu résiduel pouvant exister entre le moyen optique 3 et le support 5 du moyen optique. Cette compensation de jeu résiduel permet d'améliorer le contact entre le moyen optique 3 et le support 5 du moyen optique 3 (notamment entre leur base 30 et 50).

Dans la position de fermeture du support 5 du moyen optique 3, telle que représentée à la figure 1 :
- le moyen optique 3 et le support 5 du moyen optique 3 sont en contact. Plus particulièrement, la base 30 du moyen optique 3 et la base 50 du support 5 du moyen optique 3 sont en contact;
- le premier logement 12A et le deuxième logement 12B sont en vis-à-vis l'un de l'autre;
- la source lumineuse 7 est bloquée dans le module lumineux 10. Plus particulièrement, le support mécanique 13 des moyens d'émission de lumière 11 est :
   - bloqué horizontalement dans le premier logement 12A du moyen optique 3 ou le deuxième logement 12B du support 5 du moyen optique 3 ;
   - bloqué verticalement par le moyen optique 3 contre le support 5 de ce moyen optique 3.
La source de lumière 7 est ainsi maintenue en position dans le module optique 3. De cette manière, les moyens d'émission de lumière 11 de la source lumineuse 7 sont positionnés et bloqués dans une zone focale F du moyen optique 3. Cela permet d'avoir une bonne focalisation sur le module optique 3 et ainsi d'optimiser le faisceau lumineux.

Dans un mode de réalisation non limitatif, la source lumineuse 7 est bloquée dans le premier logement 12A ou dans le deuxième logement 12B lorsque le support 5 du moyen optique 3 est en position de fermeture :
- selon une direction longitudinale X en deux points de référence primaires 9A, 9B (décrits plus loin) via deux moyens de blocage primaires 14A, 14B, 16A, 16B, 23A, 23B (décrits plus loin) de la base 30 du moyen optique 3 ou de la base 50 du support du moyen optique 5 ;
- selon une direction transversale Y, perpendiculaire à la direction longitudinale X, en au moins un point de référence secondaire 15 (décrit plus loin) via un moyen de blocage secondaire 18 de la base 30 du moyen optique 3 (décrit plus loin).

Dans un mode de réalisation non limitatif, la source lumineuse 7 est bloquée dans le premier logement 12A et le deuxième logement 12B lorsque le support 5 du moyen optique 3 est en position de fermeture, selon une direction normale Z en des points de référence tertiaires 25A, 25B, 25C, sur lesquels le module optique 3 (en particulier sa base 30) vient appuyer lorsque le support 5 du module optique 3 est en position de fermeture.

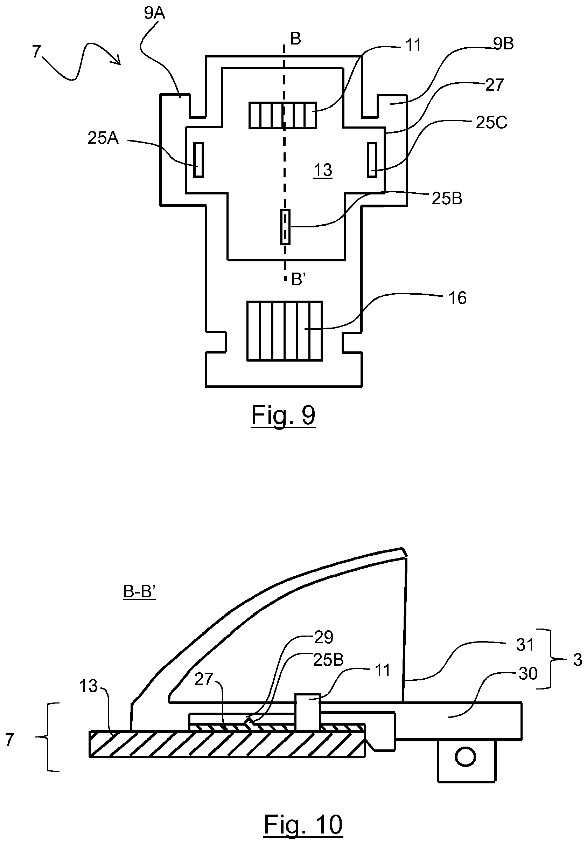

Dans un mode de réalisation non limitatif illustré à la figure 9, la source lumineuse 7 comprend trois points de référence tertiaires 25A, 25B, 25C pour bloquer la source lumineuse 7 dans le premier logement 12A et le deuxième logement 12B selon la direction normale Z.
Dans un mode de réalisation non limitatif illustré à la figure 10, les points de référence tertiaires 25A, 25B, 25C sont des ergots qui viennent se loger dans des contre-formes 29 du moyen optique 3. Dans ce cas, la base 30 du module optique 3 comprend une épaisseur dans laquelle ces contre-formes 29 sont formées. Les contre-formes 29 appuient sur les ergots de sorte qu'en position de fermeture le moyen optique 3 maintient la source lumineuse 7 en position selon la direction normale Z. La base 30 permet ainsi de gérer l'isostatisme en Z de la source lumineuse 7 via les points de références tertiaires 25A, 25B, 25C.

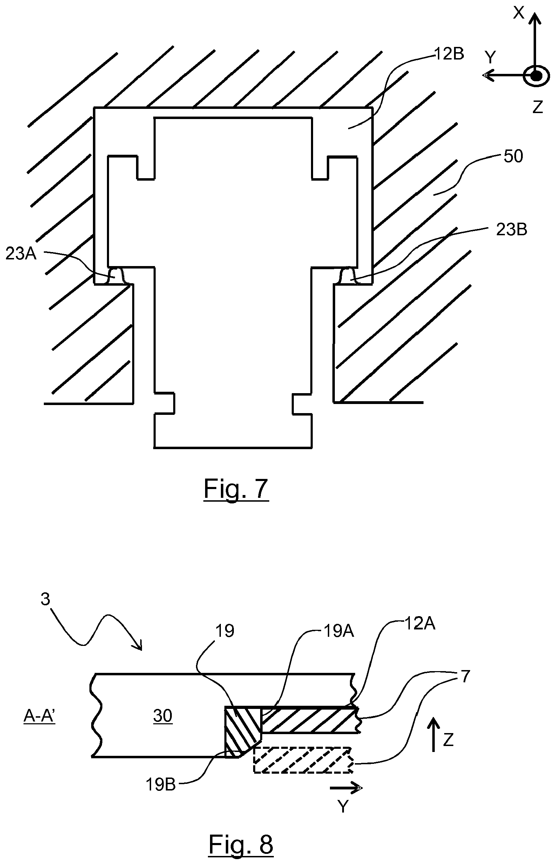

Dans un mode de réalisation non limitatif illustré sur la figure 8, la source lumineuse 7 comprend en outre un capot de protection 27. Le capot de protection 27 comprend une ouverture pour laisser passer la lumière émise par les moyens d'émission de lumière 11. Dans ce cas, les points de référence tertiaires 25A, 25B, 25C sont disposés sur le capot de protection 27. Dans l'exemple non limitatif de la figure 8, trois ergots correspondent aux points de référence tertiaires 25A, 25B, 25C.

Dans la position d'ouverture du support 5 du moyen optique 3, telle que représentée à la figure 2 :
- le moyen optique 3 et le support 5 du moyen optique 3 sont distants l'un de l'autre, à savoir ils ne sont plus en contact. Plus particulièrement, la base 30 du moyen optique 3 et la base 50 du support 5 du moyen optique 3 ne sont plus en contact;
- le premier logement 12A et le deuxième logement 12B sont distants l'un de l'autre, ils ne sont plus en vis-à-vis;
- la source lumineuse 7 demeure dans un des deux logements 12A ou 12B mais est accessible et peut être retirée du module lumineux 10. Lorsqu'elle est dans le logement 12A, la source lumineuse 7 est bloquée selon la direction transversale Y. Lorsqu'elle est dans le logement 12B, la source lumineuse 7 n'est bloquée selon aucun axe.
Un espace E est alors créé entre ce moyen optique 3 et le support 5 du moyen optique 3. Cet espace E permet à un opérateur d'accéder à la source lumineuse 7 en vue de la retirer du module lumineux 10.
On notera que cet espace E est également suffisant pour nettoyer les résidus de l'interface thermique qui se trouve entre la source de lumière 7, plus particulièrement entre son support mécanique 13 et le support 5 du moyen optique 3. On rappelle que cette interface thermique permet d'assurer une conductivité thermique entre le support 5 du moyen optique 3 et la source lumineuse 7.

Le module lumineux 10 des figures 1 et 2 est décrit ci-après selon trois modes de réalisation non limitatifs.

### • Premier mode de réalisation

Le module lumineux 10 comprend le moyen optique 3, le support 5 du moyen optique 3 et la source lumineuse décrits précédemment.

Les figures 3 et 4 représentent schématiquement respectivement la base 30 du moyen optique 3 et la base 50 du support 5 du moyen optique 3 du module lumineux 10 selon un premier mode de réalisation non limitatif.

Dans un exemple non limitatif, le moyen optique 3 est un réflecteur.
Le moyen optique 3 comporte une base 30 et un miroir 31. Le miroir 31 assure les fonctions optiques du moyen optique 3. La base 30 supporte le miroir 31 et comprend une surface de contact destinée à entrer en contact avec la base 50 du support 5 du moyen optique 3. Cette base 30 délimite le premier logement 12A du moyen optique 3 illustré à la figure 3.

Le support mécanique 13 de la source lumineuse 7 comporte deux bras adaptés pour former deux points de référence primaires 9A, 9B.

Lorsque le support 5 du moyen optique 3 est en position d'ouverture, la source lumineuse 7 est positionnée par l'opérateur dans le premier logement 12A du moyen optique 3, illustré à la figure 3.
Le support mécanique 13 est bloqué selon la direction longitudinale X par deux moyens de blocage primaires 14A, 14B. Ces deux moyens de blocage primaires 14A, 14B agissent sur le support mécanique 13 des moyens d'émission de lumière 11, de sorte que les deux points de référence primaires 9A, 9B sont en butée contre la paroi interne du logement 12A. La base 30 du moyen optique 3 permet ainsi de gérer l'isostatisme en X de la source lumineuse 7 via les points de références primaires 9A, 9B.
Dans un mode de réalisation non limitatif, les deux moyens de blocage primaires 14A, 14B sont deux lames ressorts. Ces deux lames ressorts permettent de plaquer facilement la source lumineuse 7 dans le module lumineux 10 selon la direction longitudinale X.
Le support mécanique 13 est bloqué selon la direction transversale Y par un premier moyen de blocage secondaire 18. Le premier moyen de blocage secondaire 18 agit sur le support mécanique 13, de sorte que ce support mécanique 13 vienne en butée contre un deuxième moyen de blocage secondaire 19 disposé en regard du premier moyen de blocage secondaire 18. La base 30 du moyen optique 3 permet ainsi de gérer l'isostatisme en Y de la source lumineuse 7 via le premier moyen de blocage secondaire 18 et le deuxième moyen de blocage secondaire 19.
Dans un mode de réalisation non limitatif, le premier moyen de blocage secondaire 18 est une lame ressort. Cette lame ressort permet de plaquer facilement la source lumineuse 7 dans le module lumineux 10 selon la direction transversale Y.
Dans un mode de réalisation non limitatif, le second moyen de blocage secondaire 19 est un chanfrein. Il est disposé en regard de la lame ressort 18. Le chanfrein 19 et la lame ressort 18 sont disposés de part et d'autre de la source lumineuse 7. Le chanfrein 19 a une action complémentaire à la lame ressort 18. Il permet en effet un guidage et un blocage progressif de la source lumineuse 7 dans le module lumineux 10, selon la direction transversale Y. La figure 8 est une vue en coupe A-A' de la figure 3 au niveau du chanfrein 19. Ce chanfrein comprend une partie biseautée 19B et une partie droite 19A prolongeant la partie biseautée 19B. La partie biseautée 19B est adaptée pour guider la source lumineuse 7 (illustrée en pointillés dans une position non bloquée) selon la direction transversale Y et selon la direction normale Z lorsque le support 5 du moyen optique 3 se rapproche du moyen optique 3. La partie droite 19A bloque la source lumineuse 7 (illustrée en traits pleins) dans le logement 12A de la base 30 une fois le support 5 du moyen optique 3 en position de fermeture.

Lorsque le support 5 du moyen optique 3 est ramené contre le moyen optique 3, le support mécanique 13 vient se loger dans le deuxième logement 12B délimité par la base 50 du support 5 du moyen optique 3, illustré à la figure 4. Le support 5 du moyen optique 3 est alors en position de fermeture.
Comme il a déjà été précisé, c'est la rotation du support 5 du moyen optique 3 autour de l'axe de rotation 6 qui permet de mettre le premier logement 12A et le deuxième logement 12B en vis-à-vis et les deux bases 30 et 50 en contact.
Comme on peut le voir, dans ce premier mode de réalisation, le support 5 du moyen optique 3 ne comprend pas de moyens de blocage primaire ou secondaire.
Dans ce premier mode de réalisation pour le blocage de la source lumineuse 7, on vient donc positionner cette source lumineuse d'abord dans le premier logement 12A du moyen optique 3 et ensuite dans le deuxième logement 12 B du support 5 du moyen optique 3. En procédant de cette manière, on s'assure que la source lumineuse 7 est positionnée avec précision dans le module lumineux 10 et qu'elle reste stable dans cette position

### • Deuxième mode de réalisation

Le module lumineux 10 comprend le moyen optique 3, le support 5 du moyen optique 3 et la source lumineuse 7 décrits précédemment.

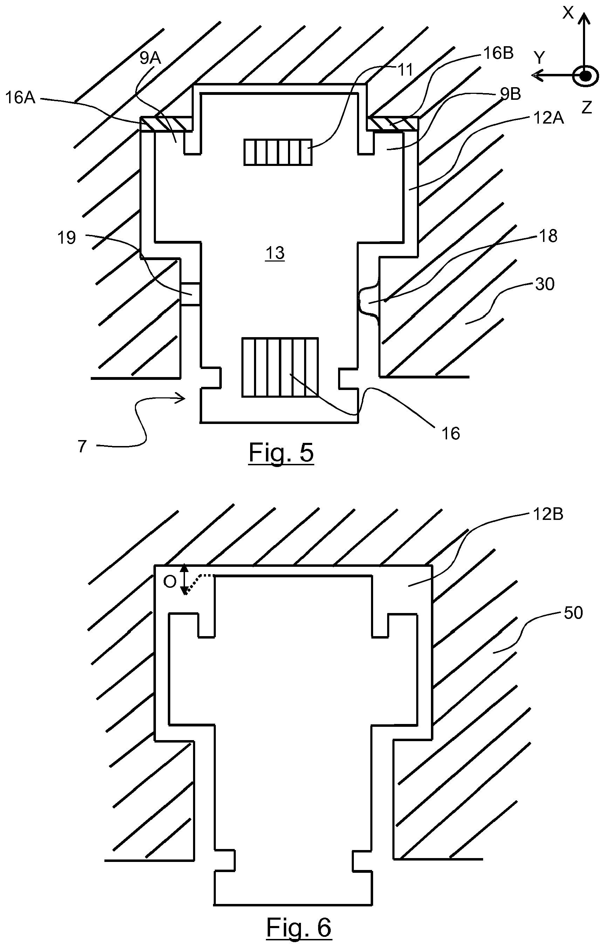

Les figures 5 et 6 représentent schématiquement respectivement la base 30 du moyen optique 3 et la base 50 du support 5 du moyen optique 3 du module lumineux 10 selon un second mode de réalisation non limitatif.
Dans un exemple non limitatif, le moyen optique 3 est un réflecteur.
Le moyen optique 3 comporte une base 30 et un miroir 31. Le miroir 31 assure les fonctions optiques du moyen optique 3. La base 30 supporte le miroir 31 et comprend une surface de contact destinée à entrer en contact avec la base 50 du support 5 du moyen optique 3. Cette base 30 délimite le premier logement 12A du moyen optique 3 illustré à la figure 3.

Le support mécanique 13 de la source lumineuse 7 comporte deux bras adaptés pour former deux points de référence primaires 9A, 9B.

Ainsi, lorsque le support 5 du moyen optique 3 est en position d'ouverture, la source lumineuse 7 est positionnée par l'opérateur dans le deuxième logement 12B du support 5 du moyen optique 3 comme il est illustré à la figure 6.
Comme on peut le voir dans ce premier mode de réalisation, le support 5 du moyen optique 3 ne comprend pas de moyens de blocage primaire ou secondaire de la source lumineuse 7. Il existe donc un jeu O entre le support mécanique 13 de la source lumineuse 7 et la paroi interne du deuxième logement 12B.
Lorsque le support 5 du moyen optique 3 est ramené contre le moyen optique 3, le support mécanique 13 vient se loger dans le premier logement 12A délimité par la base 30 du moyen optique 3, illustré à la figure 5.
Comme il a déjà été précisé, c'est la rotation du support 5 du moyen optique 3 autour de l'axe de rotation 6 qui permet de mettre le premier logement 12A et le deuxième logement 12B en vis-à-vis et les deux bases 30 et 50 en contact.

Le support mécanique 13 est bloqué selon la direction longitudinale X par deux moyens de blocage primaires 16A, 16B. Ces deux moyens de blocage primaires 16A, 16B sont disposés entre les deux points de référence primaires 9A, 9B et la paroi interne du logement 12A. La base 30 du moyen optique 3 permet ainsi de gérer l'isostatisme en X de la source lumineuse 7 via les points de références primaires 9A, 9B.

Dans un mode de réalisation non limitatif, les deux moyens de blocage primaires 16A, 16B sont ici deux chanfreins. Les chanfreins permettent un guidage et un blocage progressif de la source lumineuse 7 dans le module lumineux 10, selon la direction longitudinale X.

Le support mécanique 13 est bloqué selon la direction transversale Y par un premier moyen de blocage secondaire 18. Le premier moyen de blocage secondaire 18 agit sur le support mécanique 13, de sorte que ce support mécanique 13 vienne en butée contre un deuxième moyen de blocage secondaire 19 disposé en regard du premier moyen de blocage secondaire 18.
Dans un mode de réalisation non limitatif, le premier moyen de blocage secondaire 18 est une lame ressort. Cette lame ressort permet de plaquer facilement la source lumineuse 7 dans le module lumineux 10 selon la direction transversale Y. La base 30 du moyen optique 3 permet ainsi de gérer l'isostatisme en Y de la source lumineuse 7 via le premier moyen de blocage secondaire 18 et le deuxième moyen de blocage secondaire 19. Dans un mode de réalisation non limitatif, le second moyen de blocage secondaire 19 est un chanfrein. Il est disposé en regard de la lame ressort 18. Le chanfrein 19 et la lame ressort 18 sont disposés de part et d'autre de la source lumineuse 7. Le chanfrein 19 a une action complémentaire à la lame ressort 18. Il permet en effet un guidage et un blocage progressif de la source lumineuse 7 dans le module lumineux 10, selon la direction transversale Y.
On notera que pour les chanfreins 16A, 16B, et 19 de la figure 5, le même principe de blocage progressif que celui décrit pour le chanfrein 19 à la figure 3 utilisé dans le premier mode de réalisation non limitatif s'applique. Ainsi, la figure 8 s'applique aux chanfreins 16A, 16B et 19 de la figure 5.

Dans ce second mode de réalisation pour le blocage de la source lumineuse 7, on vient donc positionner cette source lumineuse 7 d'abord dans le deuxième logement 12B du support 5 du moyen optique 3 et ensuite dans le premier logement 12A du moyen optique 3. En position d'ouverture, il est ainsi plus facile pour un opérateur d'accéder au deuxième logement 12B en vue d'intégrer la source lumineuse 7 dans le module lumineux 10.

### • Troisième mode de réalisation

Le module lumineux 10 comprend le moyen optique 3, le support 5 du moyen optique 3 et la source lumineuse décrits précédemment.

La figure 5 représente schématiquement la base 30 du moyen optique 3 du module lumineux 10 selon un troisième mode de réalisation non limitatif également.
La figure 7 représente schématiquement la base 50 du support 5 du moyen optique 3 du module lumineux 10 selon un troisième mode de réalisation non limitatif.

De la même manière que dans le second mode de réalisation, la source lumineuse 7 est d'abord positionnée dans le deuxième logement 12B du support 5 du moyen optique 3 puis dans le premier logement 12A.

Ce troisième mode de réalisation se distingue du second mode de réalisation en ce que le support 5 du moyen optique 3 comprend deux moyens de blocage primaires 23A, 23B pour le blocage de la source lumineuse 7 selon la direction longitudinale X.
En position de fermeture, c'est-à-dire lorsque la base 30 du moyen optique 3 et la base 50 du support 5 du moyen optique 3 sont en contact, les deux moyens de blocage primaires 23A, 23B vont agir sur le support mécanique 13 de sorte que les deux points de référence primaires 9A, 9B de ce support mécanique 13 viennent en butée contre les deux moyens de blocage primaires 16A, 16B de la figure 5. On améliore ainsi le blocage de la source lumineuse 7 selon la direction longitudinale X, dans le module lumineux 10. La base 30 du moyen optique 3 permet ainsi de gérer l'isostatisme en X de la source lumineuse 7 via les points de références primaires 9A, 9B.

Dans un mode de réalisation non limitatif, les deux moyens de blocage primaires 23A, 23B sont des lames ressort. Ces lames ressorts permettent de plaquer facilement la source lumineuse 7 dans le module lumineux 10, selon la direction longitudinale X

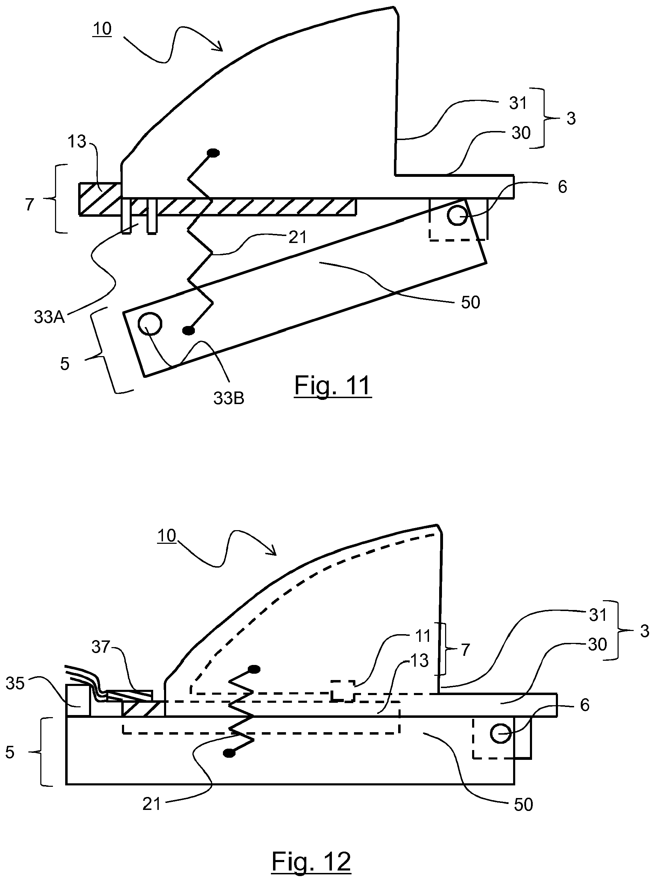

Outre le module optique 3, le support 5 du module optique 3, la source lumineuse 7 et les moyens de déplacements 21 décrits dans les trois modes de réalisation ci-dessus dans un mode de réalisation non limitatif illustré à la figure 11, le module lumineux 10 comprend des moyens de verrouillage 33A, 33B pour le verrouillage du moyen optique 3 avec le support 5 du moyen optique 3. Ces moyens de verrouillage comprennent :
- une zone de réception 33A appartenant à la base 30 du moyen optique 3 et ;
- un pion 33B appartenant à la base 50 du support 5 du moyen optique 3. Le pion 33B est adapté pour se coincer dans la zone de réception 33A lorsque le support 5 du moyen optique 3 est en position fermé.

Dans des variantes de réalisation non limitatives, les moyens de verrouillage comprennent :
- un crochet ou ;
- un système à vis;
- un verrou ou ;
- des moyens d'encliquetage ou ;
- un aimant.

Comme décrit précédemment, l'interface de connexion électrique 16 de la source lumineuse 7 est adaptée pour coopérer avec un connecteur électrique externe 37 (illustré sur la figure 10) de la source lumineuse 7. Afin d'éviter une déconnexion de ce connecteur électrique externe lors de l'utilisation du véhicule automobile, dans un mode de réalisation non limitatif illustré à la figure 12, le module lumineux 10 comprend en outre des moyens de calage 35 pour le maintien du connecteur électrique externe 37 sur le module lumineux 10. Les moyens de calage 35 appartiennent à la base 50 du support 5 du moyen optique 3.

Bien entendu, la description de l'invention n'est pas limitée aux modes de réalisation décrits ci-dessus.
Ainsi, dans un mode de réalisation non limitatif, les moyens de déplacement 21 comprennent un système à came (non représenté sur les figures). Ce système à came comprend une came et un pivot solidaire du support du moyen optique. Le système à came permet de transformer, de manière simple et pratique, un mouvement de rotation de la came autour du pivot en un mouvement de translation et/ou de rotation du moyen optique. Le système à came maintient le support du moyen optique dans sa position d'ouverture durant toute l'opération de changement de la source lumineuse. Ainsi, dans un mode de réalisation non limitatif, la source lumineuse 7 comprend en outre des moyens de préhension sur ledit support mécanique 13. Ces moyens de préhension sont disposés sur ledit support mécanique 13 à proximité de l'interface de connexion électrique 16. On notera que ces moyens de préhension sont agencés sur ledit support mécanique 13 de sorte à ne pas gêner une connexion entre un connecteur électrique externe et l'interface de connexion électrique 16.
Ainsi, dans un mode de réalisation non limitatif, la source lumineuse 7 ne comporte pas de capot de protection 27. Dans ce cas, il existe deux points de référence tertiaires et les bords du moyen optique 3 vont venir appuyer sur ces points de référence en position de fermeture.
Ainsi, dans un mode de réalisation non limitatif, le module lumineux 10 comprend deux ressorts de rappel 21 disposés en vis-à-vis de part et d'autre de la source lumineuse 7 pour favoriser le rappel du support 5 du moyen optique 3 vers le moyen optique 3.
Ainsi, dans un mode de réalisation non limitatif, il est prévu de déposer sur les parois internes du deuxième logement 12B une pâte ou une mousse thermiquement conductrice pour favoriser l'évacuation de la chaleur émise par les moyens d'émission de lumière 11 vers le support 5 du moyen optique 3.

Ainsi, l'invention décrite présente notamment les avantages suivants :
- on facilite le remplacement d'une source lumineuse défectueuse;
- il n'est pas nécessaire de retirer le moyen optique 3 pour effectuer l'opération de remplacement;
- il n'est pas nécessaire de mettre au rebut tout le moyen optique 3 juste pour remplacer une source lumineuse, ce qui réduit sensiblement le coût de remplacement de ladite source lumineuse;
- une fois la source lumineuse retirée, il est possible d'identifier et de changer uniquement l'élément défectueux de cette source lumineuse 7 ;
- on utilise un système simple à manipuler pour libérer la source lumineuse. Il suffit à l'opérateur de faire pivoter le support 5 du moyen optique 3 autour de l'axe de rotation 6.

## Revendications

1. Module lumineux (10) pour véhicule automobile, ledit module lumineux (10) comprenant :
- un moyen optique (3) monté fixe dans le module lumineux (10), ledit moyen optique (3) comprenant une base (30) avec un premier logement (12A) ;
- un support (5) du moyen optique (3) mobile par rapport au moyen optique (3) autour d'un axe de rotation (6), ledit support (5) du moyen optique (3) comprenant une base (50) avec un deuxième logement (12B), ledit support (5) du moyen optique (3) étant adapté pour prendre :
- une position de fermeture pour maintenir au moins une source lumineuse (7) en partie dans ledit premier logement (12A) et en partie dans ledit deuxième logement (12B) ; et
- une position d'ouverture pour retirer ladite au moins une source lumineuse (7) du module lumineux (10) ;
- ladite au moins une source lumineuse (7) étant amovible et comprenant :
- des moyens d'émission de lumière (11);
- un support mécanique (13) des moyens d'émission de lumière (11).

2. Module lumineux (10) selon la revendication 1, dans lequel la source lumineuse (7) est bloquée dans le premier logement (12A) ou dans le deuxième logement (12B) :
- selon une direction longitudinale (X) en deux points de référence primaires (9A, 9B) via deux moyens de blocage primaires (14A, 14B, 16A, 16B, 23A, 23B) de la base (30) du moyen optique (3) ou de la base (50) du support du moyen optique (5) ;
- selon une direction transversale (Y), perpendiculaire à la direction longitudinale (X), en au moins un point de référence secondaire (15) via un moyen de blocage secondaire (18).

3. Module lumineux (10) selon la revendication 2, dans lequel un moyen de blocage primaire est une lame ressort (14A, 14B, 23A, 23B).

4. Module lumineux (10) selon la revendication 2, dans lequel un moyen de blocage primaire est un chanfrein (16A, 16B).

5. Module lumineux (10) selon l'une quelconque des revendications 2 à 4, dans lequel un moyen de blocage secondaire est une lame ressort (18) de la base (30) du moyen optique (3).

6. Module lumineux (10) selon la revendication 5, dans lequel un deuxième moyen de blocage secondaire (19) est utilisé pour bloquer la source lumineuse (7) selon la direction transversale (Y), ledit deuxième moyen de blocage secondaire (19) étant un chanfrein de la base (30) du moyen optique (3) en regard de ladite lame ressort (18), le chanfrein (19) et la lame ressort (18) étant disposés de part et d'autre de la source lumineuse (7).

7. Module lumineux (10) selon l'une quelconque des revendications 1 à 6, dans lequel le moyen optique (3) et le support (5) du moyen optique (3) sont reliés mécaniquement entre eux pour assurer un guidage en rotation du support (5) du moyen optique (3) par rapport audit moyen optique (3).

8. Module lumineux (10) selon l'une quelconque des revendications 1 à 7, dans lequel le module lumineux (10) comporte en outre des moyens de déplacement (21) du support (5) du moyen optique (3) par rapport au moyen optique (3) adaptés pour permettre un déplacement en rotation du support (5) du moyen optique (3) entre ladite position de fermeture et ladite position d'ouverture.

9. Module lumineux (10) selon la revendication précédente 8, dans lequel les moyens de déplacement (21) sont un ressort de rappel.

10. Module lumineux (10) selon l'une quelconque des revendications 1 à 3, ou 5 à 9 dans lequel la source lumineuse (7) est adaptée pour être positionnée dans ledit premier logement (12A) du moyen optique (3) lorsque le support (5) du moyen optique (3) est en position d'ouverture.

11. Module lumineux (10) selon la revendication 10, dans lequel le moyen optique (3) comprend :
- au moins deux moyens de blocage primaires (14A, 14B) pour le blocage de la source lumineuse (7) dans le premier logement (12A) selon la direction longitudinale (X) ;
- au moins un moyen de blocage secondaire (18) pour le blocage de la source lumineuse (7) dans le premier logement (12A) selon la direction transversale (Y).

12. Module lumineux (10) selon l'une quelconque des revendications 1 à 9, dans lequel la source lumineuse (7) est adaptée pour être positionnée dans ledit deuxième logement (12B) du support (5) du moyen optique (3) lorsque ledit support (5) est en position d'ouverture.

13. Module lumineux (10) selon la revendication 12, dans lequel le moyen optique (3) comprend :
- au moins deux moyens de blocage primaires (16A, 16B) pour le blocage de la source lumineuse (7) dans le premier logement (12A) selon la direction longitudinale (X) ;
- au moins un moyen de blocage secondaire (18) pour le blocage de la source lumineuse (7) dans le premier logement (12A) selon la direction transversale (Y).

14. Module lumineux (10) selon la revendication 13, dans lequel le support (5) du moyen optique (3) comprend deux moyens de blocage primaires (23A, 23B) pour le blocage de la source lumineuse (7) dans le deuxième logement (12B) selon la direction longitudinale (X).

15. Module lumineux (10) selon l'une quelconque des revendications 1 à 14, dans lequel la source lumineuse (7) est bloquée dans le premier logement (12A) selon une direction normale (Z) en au moins trois points de référence tertiaires (25A, 25B, 25C).

16. Module lumineux (10) selon la revendication 15, dans lequel les trois points de référence tertiaires sont trois ergots (25A, 25B, 25C) appartenant à un capot de protection (27) de la source lumineuse (7), lesdits ergots (25A, 25B, 25C) étant adaptés pour coopérer avec une contre-forme (29) appartenant à la base (30) du moyen optique (3).
